# EUROPEAN PATENT APPLICATION

(11) **EP 4 407 667 A1**
(43) Date of publication of application: **31.07.2024**
(21) Application number: 23216130.7
(22) Date of filing: 13.12.2023
(51) Int. Cl.: H01L 21/687

(54) **SUBSTRATE HOLDING DEVICE AND SUBSTRATE TREATING APPARATUS PROVIDED THEREWITH**

(30) Priority: 27.01.2023 JP 2023011055
(71) Applicant: SCREEN Holdings Co., Ltd., Kyoto-shi, Kyoto 602-8585 (JP)
(72) Inventor: YANO, Wataru, Kyoto-shi, 602-8585 (JP); SATO, Ryota, Kyoto-shi, 602-8585 (JP); SHINOHARA, Takashi, Kyoto-shi, 602-8585 (JP); MIYAMOTO, Junta, Kyoto-shi, 602-8585 (JP)
(74) Representative: Kilian Kilian & Partner mbB

(57) **Abstract**

A substrate holding device includes a spin table, and three or more holders. The three or more holders each have a base and a position regulator, and are arranged on an outer periphery of the spin table while being spaced apart from one another. At least one of the holders includes a rotating base as the base that is rotatable around a longitudinal shaft axis, a rotating position regulator as the position regulator that regulates a horizontal position of the substrate on the spin table, a rotating mechanism configured to switch the rotating position regulator between a first condition and a second condition, and a pushing member that is spaced apart from the substrate when the rotating position regulator is under the first condition and pushes the substrate in a direction apart from the position regulator when the rotating position regulator is switched to the second condition.

## Description

### BACKGROUND OF THE INVENTION

### Field of the Invention

The present invention relates to a substrate holding device for contacting and supporting an outer periphery edge of a substrate, such as a semiconductor wafer, a substrate for a liquid crystal display or for an organic electroluminescence (EL) display, a glass substrate for photomask, an optical disk substrate, a magnetic disk substrate, a ceramic substrate, a substrate for a solar cell, or the like (hereinafter, simply referred to as substrate), and a substrate treating apparatus provided with the substrate holding device.

### Description of the Related Art

Examples of currently-used device of this type include one that contacts and supports an outer periphery edge of a substrate while a lower surface of the substrate is spaced apart from a spin table. See, for example, Japanese Unexamined Patent Publication No. 2014-204061A. Specifically, the spin table includes a plurality of pin bases along an outer peripheral surface of the substrate. The pin bases each include support pins. Each of the pin bases includes a rotary shaft in a longitudinal direction. The support pins are arranged apart from the rotary shaft of the pin base in plan view. The support pins restrict a horizontal position of the substrate.

When the pin base rotates in one direction, lateral side faces of the support pins contact a periphery edge of the substrate. Thereby, the substrate is held while the horizontal position thereof is determined. When the pin base rotates in another direction, the lateral side faces of the support pins are spaced apart from the peripheral edge of the substrate. This releases the substrate.

Cleaning treatment is performed as under, for example, to the substrate held by the currently-used substrate holding device. The spin table rotates while the substrate is held, thereby rotating the substrate. Then, a treatment liquid is supplied onto an upper surface of the substrate. Moreover, a brush works on the upper surface of the substrate while the brush presses against the substrate. The brush performs a scan from the center to an outer periphery edge of the substrate. Accordingly, cleaning treatment is performed to the entire upper surface of the substrate.

However, the example of the currently-used device with such a construction has the following drawback.
Specifically, the currently-used device may cause contact portions of the support pins with the substrate to be worn, whereby the outer periphery edge of the substrate cuts into the contact portions. Such a situation prevents smooth release of the substrate when the pin bases rotate. Accordingly, it is typical to change the support pins periodically with every treatment of a predetermined numbers of substrates.

Then, the support pins may be worn more rapidly than expected. In other words, there exists a problem that a lifetime of the support pins may be shorter than expected. The substrate to which various processes are performed may be bent in a thickness direction due to difference in thermal expansion coefficient. As a result, when the brush scans a convex upper surface of the substrate, the substrate vibrates in an up-down direction. Along this, the outer periphery edge of the substrate rubs against lateral side faces of the support pins. Accordingly, the progress of wearing of the support pins may be made more rapidly than expected depending on the number of scans by the brush or deflection of the substrate. In such a case as above, a frequency of replacing the support pins increases.

Here, the substrate holding apparatus is not only a movable one that rotates around a longitudinal rotary axis as described above but also one additionally including a fixed member that do not rotate. Also in this case, the outer periphery edge of the substrate is pressed against fixed support pins. This causes wearing, leading to a problem similar to that by the movable ones.

Moreover, if the substrate is not smoothly released due to the wearing of the support pins described above, there arises a case where a position of the substrate in a horizontal direction is shifted. Accordingly, a trouble may occur in delivery to a transfer arm, leading to a possibility of poor transportation. When the poor transportation occurs, a possibility that the substrate is damaged may arise. When the substrate is damaged, damages on other parts of the support pins may often occur, leading to a long time for repair. Therefore, it is important to release the substrate smoothly even when the support pins are worn.

### SUMMARY OF THE INVENTION

The present invention has been made regarding the state of the art noted above, and its object is to provide a substrate holding device and a substrate treating apparatus with the substrate holding device that enable smooth release of a substrate to achieve a long lifetime even when the substrate holding device is worn.

The present invention is constituted as stated below to achieve the above object.

One aspect of the present invention provides a substrate holding device that holds and rotates a substrate. The device includes: a spin table that rotates in a horizontal plane; and three or more holders each having a base and a position regulator protruding upward from the base and regulating a horizontal position of the substrate on the spin table by contacting an outer periphery edge of the substrate, the three or more holders being arranged on an outer periphery of the spin table while being spaced apart from one another. At least one holder of the three or more holders includes: a rotating base as the base that is rotatable around a longitudinal shaft axis; a rotating position regulator as the position regulator that protrudes toward the outer periphery edge of the substrate at a position apart from the shaft axis in plan view, and regulates the horizontal position of the substrate on the spin table by contacting the outer periphery edge of the substrate along with rotation of the rotating base; a rotating mechanism configured to rotate the rotating base to switch the rotating position regulator between a first condition in which the rotating position regulator contacts the outer periphery edge of the substrate to hold the substrate and a second condition in which the rotating position regulator is spaced apart from the outer periphery edge of the substrate to release the substrate; and a pushing member that is provided on the rotating base to protrude toward the outer periphery edge of the substrate, spaced apart from the substrate when the rotating position regulator is under the first condition, and contacts the outer periphery edge of the substrate to push the substrate in a direction apart from the position regulator when the rotating position regulator is switched from the first condition to the second condition.

According to the aspect of the present invention, when the rotating position regulator of at least one of the holders provided so as to protrude upward from the base is brought into the first condition by the rotating mechanism, the rotating position regulator holds the outer periphery edge of the substrate. When the spin table rotates and finishes treatment to the substrate, the rotating position regulator is brought from the first condition into the second condition by the rotating mechanism. At this time, the pushing member pushes the outer periphery edge of the substrate in a direction apart from the rotating position regulator. Consequently, even when the position regulator is worn by the outer periphery edge of the substrate, the outer periphery edge of the substrate is smoothly released from the position regulator. This results in lowered frequency of replacing the holders, achieving a long lifetime.

It is preferred in the aspect of the present invention that at least three of the holders each include the rotating base, the rotating position regulator, the rotating mechanism, and the pushing member.

At least three holders freely rotate, whereby the substrate can be aligned in the horizontal direction accurately.

It is preferred in the aspect of the present invention that all of the holders arranged on the outer periphery of the spin table each include the rotating base, the rotating position regulator, the rotating mechanism, and the pushing member.

Since all the holders free rotate, a frequency of replacing all the holders can be lowered, achieving a longer lifetime of the substrate holding device and a substrate treating apparatus provided with the substrate holding device.

It is preferred in the aspect of the present invention that the pushing member is provided opposite to the rotating position regulator across the shaft axis in plan view.

When the rotating position regulator moves apart from the outer periphery edge of the substrate, the pushing member approaches the outer periphery edge of the substrate conversely. Accordingly, the pushing member can push the outer periphery edge of the substrate from the rotating position regulator certainly with a simple construction.

It is preferred in the aspect of the present invention that the pushing member has a length toward the outer periphery edge of the substrate smaller than that of the rotating position regulator.

Under the first condition, the pushing member does not contact the outer periphery edge of the substrate. Accordingly, under the first condition, the outer periphery edge of the substrate can be held only with the rotating position regulator. As a result, a contact part with the outer periphery edge of the substrate can be minimized under the first condition, suppressing mutual contamination due to the contact.

It is preferred in the aspect of the present invention that the at least three holders are each positioned on a vertex of an equilateral triangle in plan view.

When the holders are each positioned on the vertex of the equilateral triangle, the substrate can be held at a minimum number of holders. This achieves a reduction in number of parts, achieving suppressed apparatus costs.

It is preferred in the aspect of the present invention that a plurality of lower surface holders are further provided to contact the lower surface of the substrate for regulating a height position of the substrate.

Since the lower surface holders regulate the height position of the substrate, the lower surface of the substrate can be prevented from contacting the spin table even when the rotating position regulator loosely holds the substrate under the first condition.

It is preferred in the aspect of the present invention that a substrate treating apparatus includes the substrate holding device and a substrate transport unit for transporting the substrate to and from the substrate holding device, and that the pushing member pushes the substrate in a direction apart from the rotating position regulator to align the substrate with the substrate transport unit.

Even when the rotating position regulator is worn by the outer periphery edge of the substrate, the substrate holders smoothly release the outer periphery edge of the substrate from the rotating position regulator by the pushing member. Consequently, the substrate on the substrate holders is hard to be shifted, achieving easy alignment of the substrate with the substrate transport unit. Therefore, falling of the substrate during transportation can be prevented in the substrate treating apparatus.

### BRIEF DESCRIPTION OF THE DRAWINGS

**For the purpose of illustrating the invention, there are shown in the drawings several forms which are presently preferred, it being understood, however, that the invention is not limited to the precise arrangement and instrumentalities shown.**
Fig. 1 illustrates an overall configuration of a substrate treating apparatus according to one embodiment of the present invention.
Fig. 2 is a plan view of an overall spin table.
Fig. 3A illustrates a first condition of a movable pin, and Fig. 3B illustrates a second condition of the movable pin in plan view.
Fig. 4 is a longitudinal sectional view of the movable pin.
Fig. 5A is a picture showing wear of a rotating position regulator, and Fig. 5B is a picture seen from an arrow direction by chain double-dashed lines in Fig. 5A.
Fig. 6 is a plan view of a movable pin according to one modification.
Fig. 7 is a plan view of a movable pin according to another modification.
Fig. 8 is a plan view of a chuck unit according to another modification.

### DESCRIPTION OF THE PREFERRED EMBODIMENTS

The following describes one embodiment of the present invention with reference to drawings.

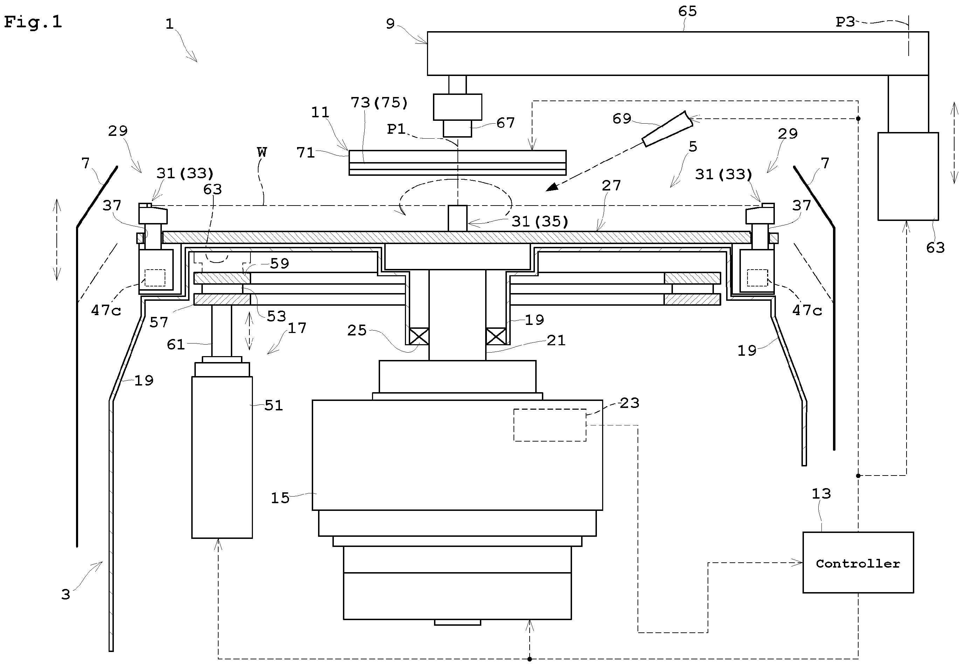

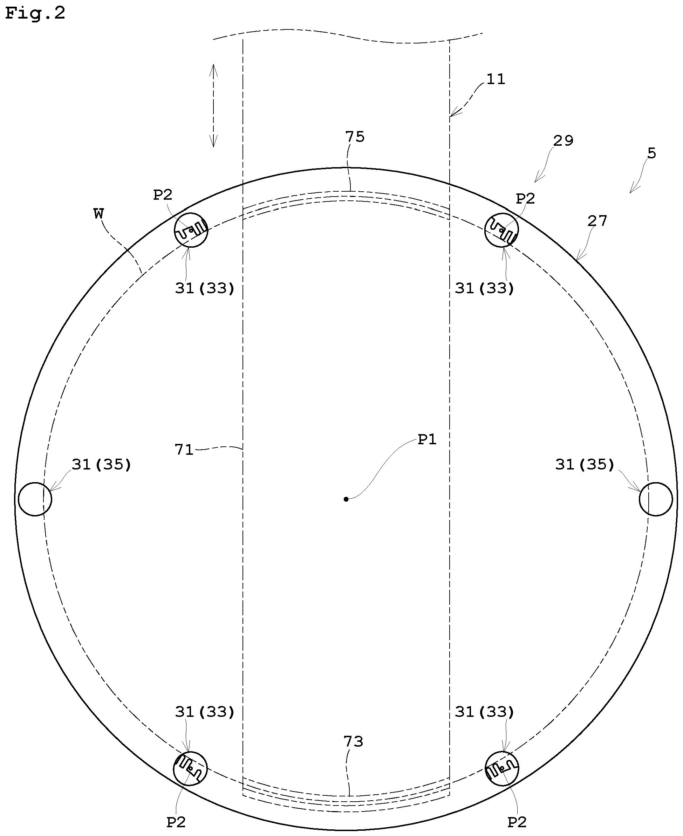

Fig. 1 illustrates an overall configuration of a substrate treating apparatus according to one embodiment of the present invention. Fig. 2 is a plan view of an overall spin table.

A substrate treating apparatus 1 according to one embodiment is a single-wafer processing apparatus for treating substrates W one by one. The substrate W has a circular shape in plan view, for example. The substrate treating apparatus 1 performs treatment on an upper surface of a substrate W, for example. Examples of the treatment include a cleaning for removing stains, such as particles, on the upper surface of the substrate W.

### <1. Overall Configuration>

The substrate treating apparatus 1 includes a base unit 3, a chuck unit 5, a guard 7, a brush cleaning unit 9, a transfer arm 11, and a controller 13.

### <2. Base unit>

The base unit 3 includes the chuck unit 5. The base unit 3 rotates the chuck unit 5. The base unit 3 holds and releases a substrate W by the chuck unit 5. The chuck unit 5 rotates the substrate W in a horizontal plane while holding the substrate W in a horizontal posture. The guard 7 prevents scattering of a supplied treatment liquid when the brush cleaning unit 9 performs cleaning treatment. The guard 7 moves upward and downward between a treatment level, denoted by solid lines in Fig. 1, and a delivery level, denoted by chain double-dashed lines in Fig. 1. The delivery level is positioned below the treatment level.

The base unit 3 includes an electric motor 15 and a switching mechanism 17.

The electric motor 15 and the switching mechanism 17 are covered with a cover 19. The cover 19 has resistance to the treatment liquid used in the apparatus of this embodiment. That is, the cover 19 has chemical resistance. The cover 19 is positioned below the chuck unit 5. Since the electric motor 15 and the switching mechanism 17 are covered with the cover 19 having chemical resistance, there is no need to perform treatment so as for the electric motor 15 and the switching mechanism 17 to have chemical resistance. Therefore, cost reduction of the base unit 3 is obtainable.

The electric motor 15 includes a rotary shaft 21. The rotary shaft 21 extends in a vertical direction. The rotary shaft 21 rotates around a shaft axis P1 in the vertical direction by the electric motor 15. The electric motor 15 outputs a rotation position of the rotary shaft 21 from an encoder 23. The rotation position is information about an angle at which a predetermined part of the rotary shaft 21 is positioned in plan view. The rotary shaft 21 has an outer periphery face attached with an inner wheel of a bearing 25. The cover 19 is attached to an outer wheel of the bearing 25. The rotary shaft 21 extends upward from the cover 19 and the bearing 25. The chuck unit 5 is attached to an upper end of the rotary shaft 21.

### <3. Chuck unit>

The chuck unit 5 includes a spin table 27 and a holding mechanism 29.

As shown in Fig. 2, the spin table 27 is circular in plan view. The spin table 27 is larger than a diameter of the substrate W. The spin table 27 has a thin plate shape. The spin table 27 is made of a material resistant to the treatment liquid supplied when the cleaning treatment is performed. For example, a fluororesin is cited as the material. More preferably, polyether ether ketone (PEEK) is cited.

The holding mechanism 29 includes a plurality of holding pins 31. In this embodiment, six holding pins 31 are provided, for example. More specifically, four of the six holding pins 31 are movable pins 33 and two are fixed pins 35. In this embodiment, the two fixed pins 35 are provided that face each other in a transverse direction as shown in Fig. 2. The movable pins 33 are each arranged at an angle of 60 degrees around the shaft axis P1 relative to the fixed pins 35. Here, the holding pins 31 described above correspond to the "holders" in the present invention.

Here, the six holding pins 31 of the holding mechanism 29 may all be movable pins 33. This makes one type of the holding pins 31, achieving suppression of apparatus costs.

The fixed pins 35 support the outer periphery edge of the lower surface of the substrate W to regulate a level of the substrate W. Specifically, the fixed pins 35 make point contact with the outer periphery edge of the lower surface of the substrate W to keep the level of the lower surface of the substrate W relative to the upper face of the spin table 27 constant.

As illustrated in Fig. 1, the spin table 27 has a plurality of through holes 37. The through holes 37 are formed adjacent to the outer periphery of the spin table 27. Specifically, the through holes 37 are formed correspondingly to positions of the six holding pins 31. The through holes 37 each penetrate from the upper face to the lower face of the spin table 27. Each of the fixed pins 33 is inserted into the through hole 37 to be fixed around the longitudinal shaft . The four movable pins 33 are each rotatably attached to the through holes 37, respectively. The movable pins 33 are attached around a shaft axis P2 in the vertical direction in a rotatable manner.

Each of the holding pins 31 is made of a material that is resistant to the treatment liquid. The holding pin 31 is preferably made of polybenzimidazole (PBI), for example. Since PBI has outstanding abrasion resistance in addition to chemical resistance, PBI is suitable for holding the substrate W. However, it is not excluded that the holding pin 31 is made of other materials. For example, the holding pin 31 may be made of another material such as fluororesin.

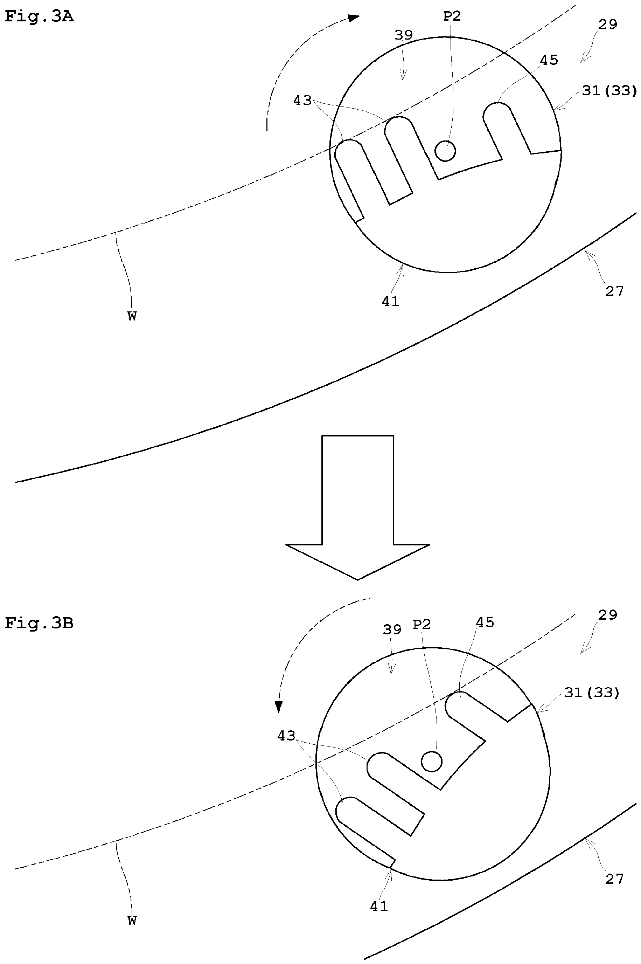

Reference is now made to Figs. 3A and 3B. Fig. 3A illustrates a first condition of the movable pin, and Fig. 3B illustrates a second condition of the movable pin in plan view.

Here, the first condition of the movable pin 33 is where the substrate W is held. The second condition of the movable pin 33 is where the substrate W is released. The first condition is a condition where the movable pin 33 is rotated around the shaft axis P2 in one direction, e.g., clockwise, in plan view. The second condition is a condition where the movable pin 33 is rotated around the shaft axis P2 in the other direction, e.g., counterclockwise, in plan view. The shaft axis P2 is formed at the center of the holding pin 31 in plan view.

The movable pin 33 has an upper part provided with a slope face 39 and a projection portion 41. The slope face 39 is positioned on a side adjacent to the shaft axis P1. The slope face 39 is formed such that an upper face thereof lowers toward the shaft axis P1 on the upper face of the movable pin 33. The projection portion 41 is positioned on a side adjacent to the outer periphery of the spin table 27. The projection portion 41 is positioned opposite to the shaft axis P1 across the shaft axis P2. The projection portion 41 includes, for example, two rotating position regulators 43. The projection portion 41 includes, for example, one pushing member 45.

The two rotating position regulators 43 are formed so as to protrude upward and toward the shaft axis P 1. Each of the rotating position regulators 43 is formed on one side whose center is the shaft axis P2. The two rotating position regulators 43 are arranged apart from each other such that lateral side faces thereof in a radial direction are substantially parallel to each other. The rotating position regulators 43 have substantially the same shape. The rotating position regulators 43 each have a semicircular shape on the side adjacent to the shaft axis P1 in plan view. The rotating position regulators 43 each contacts the outer periphery edge of the substrate W at their semicircular portions in plan view. Consequently, a minimized contact area can be obtained. This results in suppressing mutual contamination of substrates W to be treated sequentially. Here, the shape of the rotating position regulator 43 on the side adjacent to the shaft axis P1 is not limited to the semicircular shape.

The pushing member 45 is formed opposite to the two rotating position regulators 43. In other words, the pushing member 45 is formed opposite to the two rotating position regulators 43 across the shaft axis P2 in plan view. The pushing member 45 is formed on the other side relative to the shaft axis P2. The pushing member 45 is formed so as to protrude toward the shaft axis P1, which is similar to the rotating position regulator 43. However, the pushing member 45 has a length toward the outer periphery edge of the substrate W shorter than that of the rotating position regulators 43. In other words, the pushing member 45 has a distance to the outer periphery edge of the substrate W longer than that of rotating position regulator 43.

From the above, under the first condition, the pushing member 45 does not contact the outer periphery edge of the substrate W. Accordingly, under the first condition, the outer periphery edge of the substrate W can be held only with the rotating position regulators 43. As a result, a contact part with the outer periphery edge of the substrate W can be minimized under the first condition, suppressing mutual contamination due to the contact.

Here, the length of the pushing member 45 is set such that the center of the substrate W substantially conforms to the shaft axis P1 while the outer periphery edge of the substrate W is pushed toward the shaft axis P1 when the movable pins 33 is under the second condition.

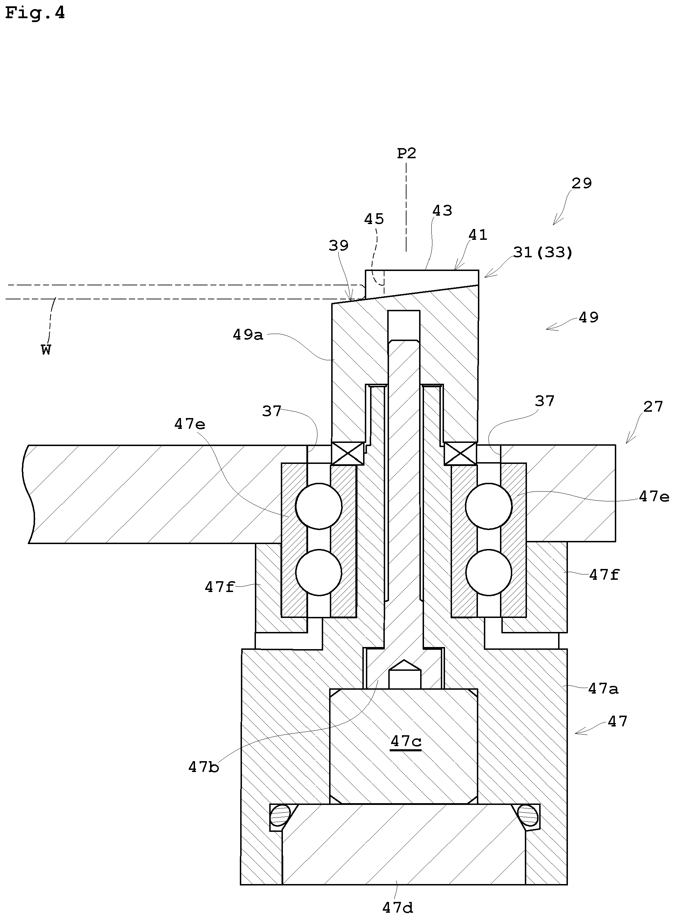

The following describes in detail a configuration of the movable pin 33 of the holding pins 31 with reference to Fig. 4. Fig. 4 is a longitudinal sectional view of the movable pin. Detailed description of the fixed pin 35 is to be omitted.

The movable pin 33 includes a bottom pin section 47 and a top pin section 49.

The bottom pin section 47 is provided below the spin table 27. The bottom pin section 47 is coupled to the top pin section 49 via the through hole 37. The bottom pin section 47 includes a pin supporting portion 47a, a fixing screw 47b, a rotation magnet 47c, a lid member 47d, a bearing 47e, and a tubular member 47f.

The top pin section 49 is fixed with the fixing screw 47b at an upper part of the pin supporting portion 47a. The rotation magnet 47c is attached to a lower part of the fixing screw 47b. The rotation magnet 47c is attached to a lower part of the movable pin 33. The rotation magnet 47c generates rotation force for rotating the movable pin 33 around the shaft axis P2 by switching the surrounding magnetic poles. The lid member 47d fixes the rotation magnet 47c to the pin supporting portion 47a. The bearing 47e and the tubular member 47f cause the pin supporting portion 47a to be attached to the through hole 37 and to rotate freely around the shaft axis P2. The pin supporting portion 47a is fixed only to an inner ring of the bearing 47e, and is not fixed to an outer ring of the bearing 47e. The outer ring of the bearing 47e is fixed to the through hole 37. The tubular member 47f fixes the outer ring of the bearing 47e on the spin table 37 while a lower face thereof is apart from an upper face of the pin supporting portion 47a.

The bearing 47e is made of a material that is resistant to a treatment liquid. For example, the bearing 47e is preferably made of, for example, conductive PEEK containing carbon nanotubes. Moreover, a rolling element of the bearing 47e is preferably made of silicon carbide (SiC). This achieves enhanced abrasion resistance of the bearing 47e.

The top pin section 49 includes a shaft 49a and the projection portion 41. The projection portion 41 includes the two rotating position regulators 43 and the pushing member 45 as described above. The shaft 49a is fixed to the pin supporting portion 47a of the bottom pin section 47 while being attached to the inner ring of the bearing 47e. The top pin section 49 contacts the lower surface and the outer periphery edge of the substrate W with the slope face 39 and the projection portion 41, thereby holding the substrate W.

Here, the shaft 49a described above corresponds to the "rotating base" in the present invention. Moreover, the fixed pins 35 described above correspond to the "lower surface holders" in the present invention.

### <5. Switching mechanism>

Reference is now made to Fig. 1. The switching mechanism 17 includes an air cylinder 51, a support arm 53, a first drive magnet 57, and a second drive magnet 59. The first drive magnet 57 is attached lower than the second drive magnet 59. In other words, the second drive magnet 59 is attached higher than the first drive magnet 57. The air cylinder 51 includes an operating shaft 61 expanding and contracting in the vertical direction. The support arm 53, the first drive magnet 57, and the second drive magnet 59 each have an annular shape in plan view. The first drive magnet 57 and the second drive magnet 59 are positioned more inward than the rotation magnet 47c in plan view. In other words, the first drive magnet 57 and the second drive magnet 59 are each positioned closer to the shaft axis P1 than the rotation magnet 47c.

The operating shaft 61 extends, for example, in a non-actuated state of the air cylinder 51. The operating shaft 61 contracts, for example, in an actuated state of the air cylinder 51. When the operating shaft 61 extends, the first drive magnet 57 moves to a level same as that of the rotation magnet 47c. When the operating shaft 61 contracts, the second drive magnet 59 moves to the level same as that of the rotation magnet 47c.

When the first drive magnet 57 moves to the level same as that of the rotation magnet 47c, the movable pins 33 rotate clockwise around the shaft axis P2 in plan view in association with magnetic poles. The magnetic poles have a relationship where the first drive magnet 57 and the rotation magnet 47c attract each other, for example. Such a state corresponds to the first condition illustrated in Fig. 3A. Thereby, the outer periphery edge of the substrate W is contacted and supported by the two rotating position regulators 43. Moreover, since the first drive magnet 57 has an annular shape in plan view, the rotating position regulator 43 can contact and support the substrate W constantly when the first drive magnet 57 is located at the same level as that of the rotation magnet 47c. Specifically, the rotating position regulator 43 can contact and support the substrate W even when the chuck unit 5 rotates.

When the second drive magnet 59 moves to the level same as that of the rotation magnet 47c, the movable pins 33 rotate counterclockwise around the shaft axis P2. The magnetic poles have a relationship where the second drive magnet 59 and the rotation magnet 47c repel each other, for example. Such a state corresponds to the second condition illustrated in Fig. 3B. Thereby, the two rotating position regulators 43 release holding of the outer periphery edge of the substrate W.

The operating shaft 61 extends when the air cylinder 51 is under a non-actuated state including a state where no electricity is supplied. Accordingly, when no electricity is supplied in a case of power failure, for example, the first drive magnet 57 moves to the level same as that of the rotation magnet 47c, whereby the substrate W is held by the movable pins 33. Consequently, there is no possibility of damages due to unintentional release of holding of the substrate W. Moreover, the second drive magnet 59 has an annular shape in plan view. Accordingly, when the second drive magnet 59 is located at the same level as that of the rotation magnet 47c, the rotating position regulator 43 can release holding of the substrate W even when the second drive magnet 59 stops at any position in the circumferential direction along with stop of rotation of the chuck unit 5.

It is preferred that the rotation magnet 47c, the first drive magnet 57, and the second drive magnet 59 described above are each a neodymium magnet, for example. The neodymium magnet is a rare-earth magnet containing neodymium, iron, and boron as main components. The neodymium magnet generates a strong magnetic field. This can achieve stable holding and certain release of the substrate W.

The switching mechanism 17 is located closer to the shaft axis P1 than the rotation magnet 47c in plan view. Consequently, the first drive magnet 57 and the second drive magnet 59 can be located adjacent to the shaft axis P1. Accordingly, a diameter of the annular support arm 53 can be shortened, achieving reduction in size of the switching mechanism 17.

Here, the rotation magnet 47c, the first drive magnet 57, and the second drive magnet 59 described above correspond to the "rotating mechanism" in the present invention.

### <6. Brush cleaning unit>

As shown in Fig. 1, the brush cleaning unit 9 includes a base part 63, an arm 65, and a brush part 67. The base part 63 can rotate around a shaft axis P3 in the vertical direction. The base part 63 is configured so as to be extendible and contractible in the vertical direction. The arm 65 has a proximal end connected to the base part 63. The arm 65 has a distal end provided with the brush part 67. The brush part 67 works on the upper surface of the substrate W to clean the upper surface of the substrate W. The brush part 67 is configured to be capable of applying pressure against the upper surface of the substrate W, for example, during treatment. The brush part 67 is configured so as to be rotatably around the vertical axis. The arm 65 swings around the shaft axis P3, whereby the base part 63 causes the brush part 67 to swing from the shaft axis P1 toward the outer periphery edge of the substrate W. This cleans the entire of the upper surface of the substrate W.

Here, the brush cleaning unit 9 may be configured so as not to move the brush part 67 by swinging but to move the base part 63 and the brush part 67 together in parallel.

A nozzle 69 is arranged adjacent to the guard 7. The nozzle 69 supplies the treatment liquid to the upper surface of the substrate W over an upper edge of the guard 7. The nozzle 69 supplies the treatment liquid to the shaft axis P1 of the rotating substrate W. A chemical liquid is cited as the treatment liquid, for example. The chemical liquid contains at least one selected from sulfuric acid, nitric acid, acetic acid, hydrochloric acid, hydrofluoric acid, ammonia water, and hydrogen peroxide solution, for example. More specifically, SC-1 as a mixed liquid of ammonia water and hydrogen peroxide solution may be used as the chemical liquid, for example.

### <7. Transfer arm>

As shown in Figs. 1 and 2, the transfer arm 11 includes an arm body, 71, a front support piece 73, and a rear support piece 75. The arm body 71 is configured so as to move forward and backward while its lower face is apart from the upper face of the spin table 27. The front support piece 73 is formed on the upper face of the arm body 71 on a distal end side. The rear support piece 75 is formed on the upper face of the arm body 71 on a rear end side. The front support piece 73 and the rear support piece 75 contact and support the outer periphery edge of the substrate W. The transfer arm 11 moves forward and backward through the holding pins 31 of the spin table 27. The transfer arm 11 delivers the substrate W to and from the spin table 27. When the movable pin 33 is switched from the first condition to the second condition, the pushing member 45 pushes the outer periphery edge of the substrate W toward the shaft axis P1, and the substrate W is positioned in the horizontal direction with the front support piece 73, the rear support piece 75, and the pushing member 45. Then, the transfer arm 11 moves upward to hold and transport the substrate W with the front support piece 73 and the rear support piece 75.

Here, the transfer arm 11 described above corresponds to the "substrate transport unit" in the present invention.

### <8. Controller>

The controller 13 controls en bloc each element of the apparatus mentioned above. The controller 13 is formed with a CPU and a memory, and the like. The controller 13 controls rotation of the electric motor 15. The controller 13 controls a position where the electric motor 15 stops in accordance with a signal from the encoder 23. Specifically, the controller 13 controls the position so that the spin table 27 stops while the transfer arm 11 and the holding pins 31 do not interfere each other. The controller 13 controls upward and downward movement of the first drive magnet 57 and the second drive magnet 59 by the switching mechanism 17. The controller 13 controls a level of the guard 7 between a treatment level and a delivery level. The controller 13 operates the base part 63 to control upward and downward movement of the brush part 67, movement of the brush part 67 on the surface of the substrate W, a rotational speed of the brush part 67, and pressure of the brush part 67. The controller 13 controls supply of the treatment liquid from the nozzle 69.

### <Specific example of treatment>

The substrate treating apparatus 1 configured in such a manner as above performs the following processing as under. Now in an initial state, the operating shaft 61 of the air cylinder 51 contracts, the second drive magnet 59 faces the rotation magnet 47c, and the movable pins 33 rotate counterclockwise. That is, the four movable pins 33 are rotated in such a manner as shown in Fig. 3B to be under the second condition.

The controller 13 causes the guard 7 to move to the delivery level. The controller 13 causes the transfer arm 11, supporting the substrate W to be treated, to move to the above of the spin table 27. The controller 13 causes the transfer arm 11 to move downward to move and place the substrate W on the slope faces 39 of the fixed pins 35 and the movable pins 33. The controller 13 causes the transfer arm 11 to move outside of the spin table 27. The controller 13 causes the switching mechanism 17 to extend the operating shaft 61 of the air cylinder 51. Thereby, the first drive magnet 57 faces the rotation magnet 47c, the movable pins 33 are rotated clockwise, and the outer periphery edge of the substrate W is contacted and supported by the rotating position regulators 43 of the movable pins 33. That is, the four movable pins 33 are rotated in such a manner as shown in Fig. 3A to be under the first condition. In other words, the outer periphery edge of the substrate W is sandwiched with the four movable pins 33.

The controller 13 rotates the electric motor 15 to rotate the substrate W at a treatment speed in accordance with a recipe. The controller 13 supplies the treatment liquid from the nozzle 69 to the center of the substrate W. The controller 13 operates the base part 63 to move the brush part 67 to the center of the substrate W, and to press the brush part 67 until pressure of the brush part 67 reaches pressure at the treatment. The controller 13 operates the base part 63 to move the brush part 67 to the outer periphery edge of the substrate W. Such scan is repeated predetermined times in accordance with the recipe. When the scan for predetermined times is finished, the controller 13 causes the brush part 67 to retract and stops supply of the treatment liquid from the supply nozzle 69. The controller 13 switches a rotation number of the electric motor 15 to a high rotation number to perform spin drying to the substrate W. When the spin drying is finished, the controller 13 stops rotation of the electric motor 15. At this time, the spin table 27 stops at a position where the transfer arm 11 and the holding pins 31 do not interfere each other.

The controller 13 causes the transfer arm 11 to move to the spin table 27. The controller 13 causes the switching mechanism 17 to contract the operating shaft 61 of the air cylinder 51. Thereby, the four movable pins 33 release the substrate W. At this time, as shown in Figs. 3A to 3B, the pushing member 45 moves so as to push the outer periphery edge of the substrate W toward the shaft axis P1.

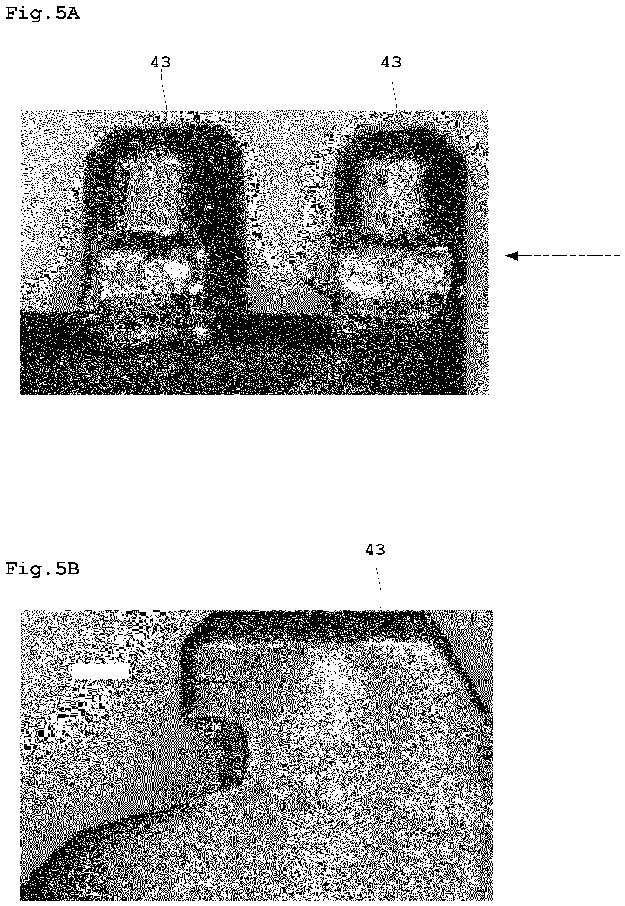

Reference is now made to Figs. 5A and 5B. Fig. 5A is a picture showing wear of the rotating position regulator, and Fig. 5B is a picture seen from an arrow direction by chain double-dashed lines in Fig. 5A.

In such a manner as described above, the substrate treating apparatus 1 performs cleaning treatment while rotating the substrate W. When this is successively executed, a lateral side face of the movable pin 33 at the rotating position regulator 43 is particularly worn. One example of such a condition is shown in Figs. 5A and 5B. In this example, the lateral side face of the rotating position regulator 43 toward the shaft axis P1 is worn by approximately 0.7 mm outward. When such wear occurs, with the construction of the currently-used movable pins 33, the outer periphery edge of the substrate W cuts into a worn portion even when the movable pin 33 rotates, leading to impossibility of smooth release. In this embodiment, the movable pin 33 includes the pushing member 45. Accordingly, even when the outer periphery edge of the substrate W cuts into the worn portion, the outer periphery edge of the substrate W is pushed toward the shaft axis P1. Therefore, the substrate W can be released smoothly even when the movable pin 33 is worn.

Moreover, when the pushing member 45 pushes the outer periphery edge of the substrate W toward the shaft axis P1, the substrate W is aligned with the front support piece 73 and the rear support piece 75 of the transfer arm 11. That is, the substrate W is released such that the center of the substrate W conforms to the shaft axis P1. Accordingly, the substrate W can be prevented from being shifted in the horizontal direction, leading to prevention of poor transportation caused by a trouble in delivery to and from the transfer arm 11.

According to this embodiment, when the movable pin 33 is brought into the first condition, the rotating position regulator 43 holds the outer periphery edge of the substrate W. When the spin table 27 rotates and finishes the treatment to the substrate W, the rotating position regulator 43 is brought from the first condition into the second condition by the rotation magnet 47c. At this time, the pushing member 45 pushes the outer periphery edge of the substrate W in a direction apart from the rotating position regulator 43. Consequently, even when the rotating position regulator 43 is worn by the outer periphery edge of the substrate W, the outer periphery edge of the substrate W is smoothly released from the rotating position regulator 43. This results in lowered frequency of replacing the movable pin 33, leading to a long lifetime.

Moreover, the holding mechanism 29 includes the holding pins 31 which all correspond to the movable pins 33, and thus does not include any fixed pin used for contacting and supporting the outer periphery edge of the substrate W to align the substrate W in the horizontal direction. In the currently-used apparatus, a degree of sandwiching the substrate W by rotation of the movable pins 33 varies. Accordingly, when all the holding pins 31 are formed with the movable pin 33, alignment of the substrate W in the horizontal direction cannot be performed accurately. However, in this embodiment, all the movable pins 33 include the pushing member 45. Accordingly, the outer periphery edge of the substrate W is biased by the pushing member 45 toward the center of the substrate W. As a result, the substrate W can be aligned in the horizontal direction accurately even with a configuration where all the holding pins 31 rotate.

### <First modification>

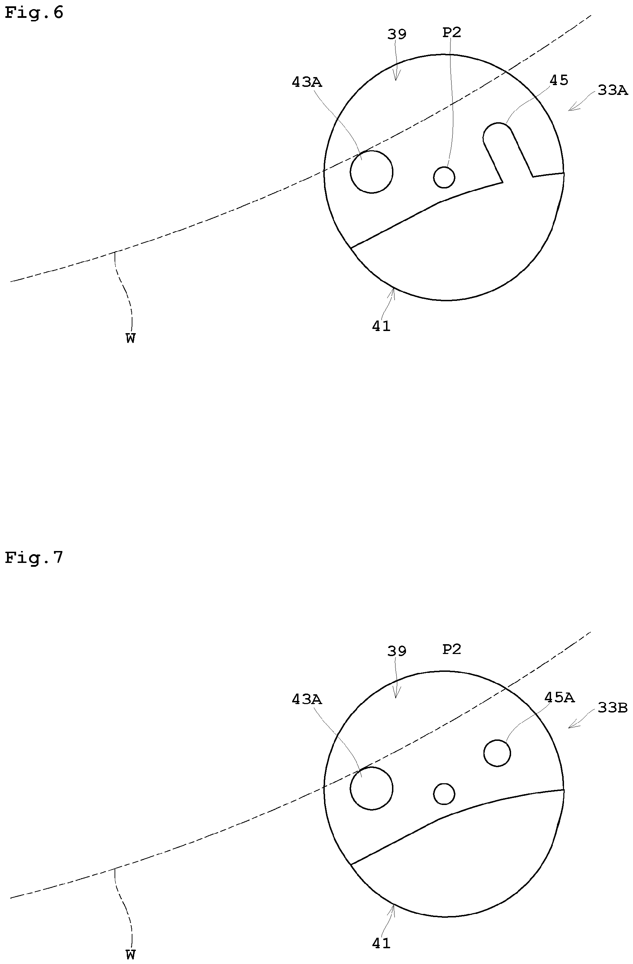

Reference is now made to Fig. 6. Fig. 6 is a plan view of a movable pin according to one modification.

In the embodiment described above, the movable pin 33 includes the two rotating position regulators 43 formed so as to protrude upward and toward the shaft axis P1. The number of the rotating position regulators 43 may be one. Moreover, as shown in Fig. 6, a movable pin 33A may include one rotating position regulator 43A that is erect and has a cylindrical shape. The rotating position regulator 43 having the cylindrical shape enables the movable pin 33A easily. Moreover, the movable pin 33A may include two rotating position regulators 43A in a cylindrical shape. The rotating position regulators 43A having the cylindrical shape can suppress stagnation of the treatment liquid, supplied to the substrate W and flowing toward the outer periphery edge, at the movable pin 33A.

### <Second modification>

Reference is now made to Fig. 7. Fig. 7 is a plan view of a movable pin according to another modification.

As shown in Fig. 7, not only a movable pin 33B but also a pushing member 45A is configured in a cylindrical shape. The pushing member 45A having the cylindrical shape enables the movable pin 33 easily. The rotating position regulator 43A and the pushing member 45A having the cylindrical shape can further suppress stagnation of the treatment liquid, supplied to the substrate W and flowing toward the outer periphery edge, at the movable pin 33B.

### <Third modification>

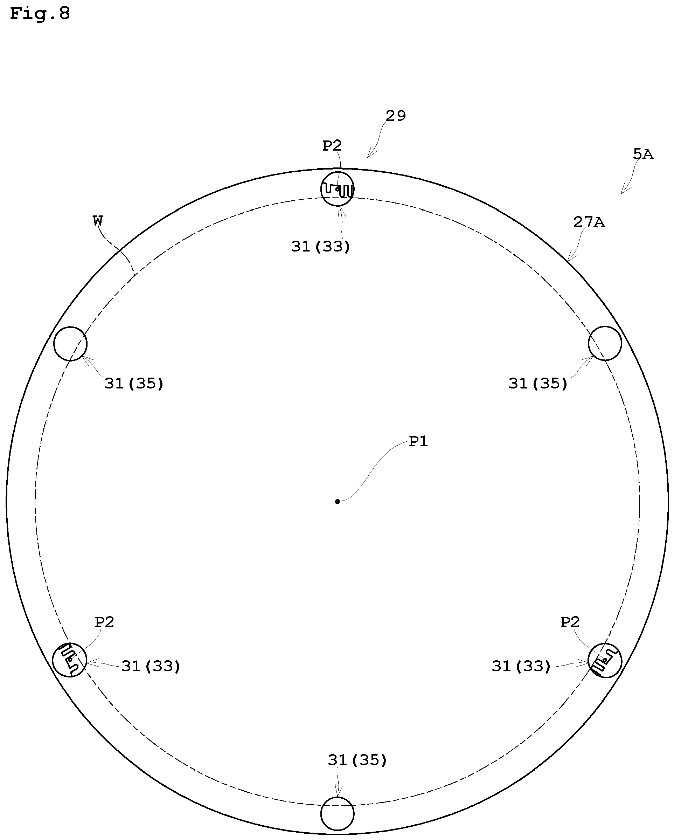

Reference is made to Fig. 8. Fig. 8 is a plan view of a chuck unit according to another modification.

The chuck unit 5 described above includes the holding mechanism 29 having the four movable pins 33 and the two fixed pins 35. A chuck unit 5A according to this modification includes a holding mechanism 29 having three movable pins 33 and three fixed pins 35. The three movable pins 33 are each arranged on a vertex of an equilateral triangle adjacent to an outer periphery of a spin table 27A in plan view. The three fixed pins 35 are each arranged on a vertex of an equilateral triangle adjacent to an outer periphery of a spin table 27A in plan view, and are shifted by 90 degrees relative to the three movable pins 33 around the shaft axis P1.

Here, such a configuration may be adopted that a fixed pin 35 is omitted since the movable pin 33 includes a slope face 39 and a height position of the substrate W can be regulated. Accordingly, the number of holding pins 31 can be minimized while the substrate W is stably held. This achieves reduction in apparatus cost.

The present invention is not limited to the foregoing examples, but may be modified as follows.
(1) In the embodiment described above, the substrate treating apparatus 1 has been described as one example that causes the brush part 67 to work on the upper surface of the substrate W while the treatment liquid is supplied from the nozzle 69. However, the present invention is not limitative to such a substrate treating apparatus 1. That is, any apparatus can be applied as long as it holds and treat the substrate W with the movable pins 33.
(2) The embodiment described above adopts a rotating construction that the movable pins 33 rotate in a non-contact manner with magnetic force. However, the present invention is not limited to this construction. That is, such a construction can be adopted in which the movable pins 33 rotate in a directly-contact manner via a link mechanism and the like.
(3) The embodiment described above adopts a construction that the movable pins 33 each have the slope face 39 to contact and support the lower surface of the outer periphery edge of the substrate W. However, the movable pin 33 need not include the slope face 39 contacting the substrate W, and may include only the rotating position regulator 43 and the pushing member 45.
(4) In the embodiment described above, the apparatus has been described as one example that performs treatment to the substrate W with the circular shape in plan view. However, the present invention is not limited to such a substrate W. For example, an apparatus that performs treatment on a substrate W in a rectangular shape can also be applied.
(5) In the embodiment described above, such an apparatus has been described as an example in which three or four movable pins 33 (holding pins 31) each provided with the pushing member 45 and the rotating position regulator 43 are arranged on a side adjacent to the outer periphery of the spin table 27. However, the present invention is not limitative to such the construction of the apparatus. That is, one movable pin 33 (holding pin 31) provided with the pushing member 45 and the rotating position regulator 43 may be arranged on a side adjacent to the outer periphery of the spin table 27. In this case, the other holding pins 31 each have a shaft 49a provided with only a position regulator similar to the rotating position regulator 43 and the shaft 49a (corresponding to the "base part" in the present invention) does not rotate. Even with such a construction, the rotating position regulator 43 of the movable pin 33 is brought from the first condition to the second condition, whereby the substrate W is pushed by the pushing member 45 in a direction apart from the rotating position regulator 43 and the position regulator. Consequently, even when the rotating position regulator 43 and the position regulator are worn by the outer periphery edge of the substrate W, the outer periphery edge of the substrate W is smoothly released from the rotating position regulator 43 and the position regulator. This results in lowered frequency of replacing the holding pin 31, achieving a long lifetime.

The present invention may be embodied in other specific forms without departing from the spirit or essential attributes thereof and, accordingly, reference should be made to the appended claims, rather than to the foregoing specification, as indicating the scope of the invention.

## Claims

1. A substrate holding device that holds and rotates a substrate, the device comprising:
a spin table that rotates in a horizontal plane; and
three or more holders each having a base and a position regulator protruding upward from the base and regulating a horizontal position of the substrate on the spin table by contacting an outer periphery edge of the substrate, the three or more holders being arranged on an outer periphery of the spin table while being spaced apart from one another, wherein
at least one holder of the three or more holders includes:
a rotating base as the base that is rotatable around a longitudinal shaft axis;
a rotating position regulator as the position regulator that protrudes toward the outer periphery edge of the substrate at a position apart from the shaft axis in plan view, and regulates the horizontal position of the substrate on the spin table by contacting the outer periphery edge of the substrate along with rotation of the rotating base;
a rotating mechanism configured to rotate the rotating base to switch the rotating position regulator between a first condition in which the rotating position regulator contacts the outer periphery edge of the substrate to hold the substrate and a second condition in which the rotating position regulator is spaced apart from the outer periphery edge of the substrate to release the substrate; and
a pushing member that is provided on the rotating base to protrude toward the outer periphery edge of the substrate, spaced apart from the substrate when the rotating position regulator is under the first condition, and configured to contact the outer periphery edge of the substrate to push the substrate in a direction apart from the position regulator when the rotating position regulator is switched from the first condition to the second condition.

2. The substrate holding device according to claim 1, wherein
at least three holders of the three or more holders each include:
the rotating base;
the rotating position regulator;
the rotating mechanism; and
the pushing member.

3. The substrate holding device according to claim 1, wherein
all of the holders arranged on the outer periphery of the spin table each include:
the rotating base;
the rotating position regulator;
the rotating mechanism; and
the pushing member.

4. The substrate holding device according to claim 1, wherein
the pushing member is provided opposite to the rotating position regulator across the shaft axis in plan view.

5. The substrate holding device according to claim 2, wherein
the pushing member is provided opposite to the rotating position regulator across the shaft axis in plan view.

6. The substrate holding device according to claim 3, wherein
the pushing member is provided opposite to the rotating position regulator across the shaft axis in plan view.

7. The substrate holding device according to claim 1, wherein
the pushing member has a length toward the outer periphery edge of the substrate smaller than that of the rotating position regulator.

8. The substrate holding device according to claim 2, wherein
the pushing member has a length toward the outer periphery edge of the substrate smaller than that of the rotating position regulator.

9. The substrate holding device according to claim 3, wherein
the pushing member has a length toward the outer periphery edge of the substrate smaller than that of the rotating position regulator.

10. The substrate holding device according to claim 2, wherein
the at least three holders are each positioned on a vertex of an equilateral triangle in plan view.

11. The substrate holding device according to claim 1, wherein
a plurality of lower surface holders are further provided to contact the lower surface of the substrate for regulating a height position of the substrate.

12. The substrate holding device according to claim 2, wherein
a plurality of lower surface holders are further provided to contact the lower surface of the substrate for regulating a height position of the substrate.

13. The substrate holding device according to claim 3, wherein
a plurality of lower surface holders are further provided to contact the lower surface of the substrate for regulating a height position of the substrate.

14. A substrate treating apparatus comprising:
the substrate holding device according to claim 1; and
a substrate transport unit for transporting the substrate to and from the substrate holding device, wherein
the pushing member pushes the substrate in a direction apart from the rotating position regulator to align the substrate with the substrate transport unit.

15. A substrate treating apparatus comprising:
the substrate holding device according to claim 2; and
a substrate transport unit for transporting the substrate to and from the substrate holding device, wherein
the pushing member pushes the substrate in a direction apart from the rotating position regulator to align the substrate with the substrate transport unit.
